# EUROPEAN PATENT SPECIFICATION

(11) **EP 1 962 098 B1**
(45) Date of publication and mention of the grant of the patent: **30.12.2009**
(21) Application number: 07003870.8
(22) Date of filing: 26.02.2007
(51) Int. Cl.: G01R 11/24, H02J 13/00

(54) **Electric energy consumption meter with power line switch**
Stromverbrauchsmessgerät mit Stromnetzschalter
Mesure de consommation d'énergie électrique avec commutateur de ligne d'alimentation

(43) Date of publication of application: 27.08.2008
(73) Proprietor: KAMSTRUP A/S, 8660 Skanderborg (DK)
(72) Inventor: Drachmann, Jens, 8260 Viby J (DK); Skallebæk, Anders, 8660 Skanderborg (DK)
(74) Representative: Plougmann & Vingtoft A/S

(56) References cited:
- EP-A- 1 607 752
- US-A1- 2004 150 384

## Description

### Field of the invention

The invention relates to the field of electric energy consumption meters, especially electric energy consumption meters with a power line switch. More specifically, the invention provides an electric energy consumption meter with a power line switch actuated by an actuator via a mechanical coupling arrangement. Further, the invention provides an electric supply system with such electric energy consumption meter.

### Background of the invention

In an electric energy distribution net supplying energy to a number of consumers, the electric energy provider needs to be able to disconnect the power line to individual consumers for a short or long period of time, e.g. in case a consumer does not pay the charges to the electric energy provider. In order to disconnect a consumer, it has been common to send an operator to the consumer and manually disconnect the power line to the consumer. However, this is an inconvenient and expensive solution.

Thus, different solutions exist to remotely disconnect the power line to a consumer. E.g. power relays for disconnecting the power line can be mounted in the consumer's electric energy consumption meter, wherein the power relay is wirelessly controllable or controllable via a high frequency control signal transmitted via the power line. Such a solution is disclosed in document US 2004/0150384 A1. With such solutions, the provider can disconnect and re-connect the consumer in an easy way. However, normal power relays are based on electromagnetic actuation. Therefore, if the relay is mounted such that it is available for the consumer, e.g. if mounted inside the consumer's electric consumption meter, such relay suffers from malfunction in case it is exposed to a strong magnetic field. Thus, it is possible for a consumer to block the relay such that it is impossible for the provider to disconnect his power line by applying a strong magnet close to the relay.

Therefore, there is a need for a power line switch device capable of functioning reliably in a strong magnetic field. For application within high power switching, a preferred distance of at least 0.5 mm between the contact members in a disconnected state of the switch is required in order to avoid the risk of sparks between the contact members and resulting damage of the contact members which will lead to an unreliable function of the switch.

### Summary of the invention

Thus, according to the above explanation, it is an object of the present invention to provide an electric energy consumption meter with a power line switch to break electric energy supply. The switch must be able to function reliably also in a strong magnetic field. Further, the power line switch must be able to handle currents of at least 50 A with a low "on" resistance.

This object is obtained in a first aspect of the invention providing an electric consumption meter for measuring an amount of electrical energy delivered by an electric power line, the meter comprising.
- a measuring device arranged to measure the amount of electric energy delivered by the electric power line, and to generate a data value representing the measured amount of electric energy,
- a power line switch arranged for connecting the electric power line in a first state and for disconnecting the electric power line in a second state, wherein the switch is arranged to switch between the first and second states upon actuation of a switch member,
- a communication module (1107) arranged to receive a control signal (CS) from an associated external transmitter.
- an actuator operationally arranged to actuate the switch member in response to a control signal, wherein actuation of the switch member involves a plurality of repeated movements of at least one part of the actuator, and
- a mechanical energy storage arrangement connecting the actuator and the switch member to collect mechanical energy produced by the actuator and to release the collected mechanical energy for actuation of the switch member.

By power line switch is understood a switch capable of handling currents of 50 A or more. Thus, such meter is suited for mounting in dwellings or enterprises for measuring consumed electrical energy delivered to a consumer by the power line. The meter is capable of breaking a power line supply connection of a consumer, e.g. by a control signal provided remotely from an electricity provider.

The meter is advantageous over traditional meters, since it provides a power line switch capable of providing a large mechanical force to press contact members of the switch together in its "on" state. Hereby, it is possible to obtain a low contact resistance in the switch and a high reliability of the switch function due to a large contact force serving to reduce influence of possible non-conductive particles on the switch contact surfaces, such as dirt or coatings on the contact surfaces caused by sparks. A large contact force also reduces the risk of malfunction due to contact members being damaged due to wear.

A large contact force is made possible due to the repeated movements performed by the actuator to actuate the switch member. Hereby, a rather small and weak actuator can be used. Further, since mechanical energy produced by the actuator is collected in the mechanical energy storage arrangement, it is possible to drive the actuator for a long period of time and thereby build up a large amount of mechanical energy before releasing it. This is especially possible if actuation of the switch does not need to occur promptly in response to the control signal, and this is normally not a critical parameter concerning disconnection of a power line in connection with a consumption meter.

The plurality of repeated movements of a part of the actuator to actuate the switch further serves to provide a switch function which is magnetically insensitive to a strong magnetic field compared to a switch based on an electro-magnetic relay. To obtain a fully magnetically immune switch function it may be preferred to use a non-magnetic actuator, e.g. a piezo-electric motor, but even if e.g. an electro-magnetic motor is used as actuator, the actuation of the switch in response to the control signal is possible even in a strong magnetic field. Further, in contrast to a normal electro-magnetic relay switch, even though the function of the actuator may be inhibited, it is not possible to provoke actuation of the switch by applying a strong magnetic field,

Still further, the combination of the repeated movements of at least one part of the actuator and the mechanical energy storage arrangement enables use of a small and weak low cost actuator for providing sufficient mechanical energy to drive two, three, four, or even more power line switches. Thus, a very low cost and compact arrangement can be provided to switch three phases and a neutral conductor, while separate electro-magnetic relays with considerable dimensions are required to provide the same function.

In preferred embodiments, actuation of the switch member further involves a plurality of repeated movements of at least one part of the mechanical energy storage arrangement. E.g. repeated rotational movements or repeated ellipsoidal movements. The actuator may include at least one part performing a plurality of rotations around an axle, e.g. as in a rotating type miniature electro-motor.

In preferred embodiments, the meter includes a casing for housing the measuring device, the power line switch, the actuator and the mechanical energy storage arrangement. Preferably, at least the actuator is located in the casing such that when the meter is mounted, e.g. on a wall, for normal operation, it is difficult for a person to place a large magnet to influence the actuator function from outside the case without tampering with the sealed opening of the casing. Thus, preferably the actuator is located in the casing such that an outer surface of the casing causes a substantial distance to the actuator from an outside magnet, thereby reducing the magnetic influence on the actuator from the magnet.

In some embodiments, to obtain a large distance to the actuator, the actuator is located in the casing behind at least one of: user interface and electronic circuits. The actuator may be mounted in a rear part of the casing, such as the actuator being attached to a rear panel of the casing. Further, both of the actuator, the power line switch and the mechanical energy storage arrangement are attached to a rear panel of the casing.

The actuator may include a piezo-electric motor or an electro-magnetic motor. The actuator may be capable of moving in two directions, e.g. such that the actuator is capable of actuating the switch member in a first movement direction so as to switch from the first state to the second state, and further capable of actuating the switch member in a second movement direction so as to switch from the second state to the first state.

Preferably, the mechanical energy storage arrangement includes a spring member serving to collect mechanical energy produced by the actuator. The actuator may be connected to actuate the switch member via a threaded spindle. The actuator may be connected to actuate the switch member via a toothed wheel arrangement.

The meter preferably includes a power supply for delivering power for operation of the measuring device and the actuator.

In the meter, a feedback signal representing the state of the switch, may be provided, such feedback signal being based on either one or both of: 1) a direct detection, such as an electric measurement performed on the power line, e.g. measurement of a voltage between neutral and one phase at a position of the power line after the switch, and hereby directly detect if the power line has been disconnected or not, and 2) an indirect detection, such as detection of a position of a mechanical part of the switch, e.g. the switch member or a part connected thereto. The feedback signal can then be applied to the drive circuit controlling the actuator in response to the control signal. Thus, the feedback signal can be used by the drive circuit to control the actuator, e.g. cut off the drive signal, once the feedback signal indicates that the switch has reached the desired state.

In embodiments where the feedback signal is provided based on an indirect detection of the state of the switch, by detecting a position of a mechanical part of the switch, the feedback signal can be obtained in a large variety of ways. E.g. the feedback signal may be provided by an electrical measurement on a separate switch, e.g. a miniature low power switch, mechanically connected to the switch member such that its switch state reflects the switch state of the power line switch. More alternatively, the feedback signal may be provided on the basis of measurements on a variable capacitor mechanically connected to reflect the switch state of the power line switch. More alternatively, the feedback signal may be provided based on a variable inductor mechanically connected to reflect the switch state of the power line switch. More alternatively, the feedback signal may be provided based on a variable resistor mechanically connected to reflect the switch state of the power line switch. Still further alternatively, the feedback signal may be provided by optical sensing of the switch state of the power line switch, e.g. using a photo-interrupter or a photo-reflector.

The feedback signal and the control signal may be applied to a microprocessor serving to control the actuator in response to the control signal. Especially, the microprocessor may be part of the measuring device of the meter.

The meter may include a plurality of power line switches arranged to disconnect respective electric phases, e.g. three phases, of the power line in response to the control signal. These power line switches may be actuated by one common actuator or by respective actuators. The meter may include a power line switch arranged to disconnect a neutral conductor of the power line in response to the control signal.

In addition to one or more power line switch(es) for disconnecting the electric supply power line, the meter may include one or more power line switch(es) with a separately controllable actuator and associated mechanical energy storage arrangement. Such additional power line switch arrangement can be used to switch on and off a connected external electric device, e.g. a washing machine, in control to a control signal from outside. E.g. the additional power line switch(es) can be actuated in control to outside information regarding a current electrical energy tariff such that the device is only switched on in case the tariff is below a predetermined value. The additional power line switch(es) can be arranged for control from either the electricity provider or the consumer.

The communication module may further be arranged to transmit the data value representing the measured amount of electric energy to an associated external receiver. Especially, the communication module may be arranged to transmit data representing an actual state of the power line switch to an associated external receiver, thus indicating e.g. to a provider that a requested disconnection has actually taken place. Still further, the communication module may be arranged to transmit data representing one or more of: voltage, current, phase angle, tariff data, collected data, prepayment data, and data indicating tampering of the meter casing.

The communication module may be arranged to communicate via one or more of: wireless Radio Frequency signals, the electric power line itself, and/or a dedicated communication wire.

In a second aspect, the invention provides a supply system for supply of electric energy to a plurality of associated consumers via a net of electric power lines, the system including
- a plurality of electric consumption meters according to embodiments of the first aspect including a respective communication modules arranged to receive a respective control signals from an associated external transmitter, the meters being arranged to disconnect respective electric power lines supplying electric energy to each of the associated consumers upon receiving respective control signals, and
- a transmitter arranged to transmit respective control signals to the plurality of electric consumption meters so as to disconnect electric energy supply to the respective associated consumers.

With such supply system an electricity provider can remotely and still reliably control connection and disconnection of individual consumers connected to the electrical supply net.

The transmitter and the electric consumption meters may be arranged to communicate the respective control signals in a wireless Radio Frequency representation and/or via the net of electric power lines, and/or via a dedicated communication wire. The respective communication modules in the respective meters are preferably arranged to transmit respective data values representing the respective measured amount of electric energy.

Further, the communication modules of the meters may be arranged to for one-way or two-way inter-communication with other meters in the system, thus forming a communication network. E.g. the meters may exchange data regarding amount of electrical energy, data regarding actual state of their power lines switches etc. Thus, in case of a wireless RF communication rather weak RF transmitters can be used, and still reading of consumed electrical energy values for the entire supply system can be performed over long distances by utilizing the inter-communication network between meters. It is only required that all of the meters in the system can communicate with at least one other meter in the network.

It is appreciated that any sub aspect mentioned in connection with the first aspect may in any way be combined with any of the sub aspects of the second aspect.

### Brief description of drawings

In the following, the invention will be described in more details by referring to embodiments illustrated in the accompanying drawings, of which
Fig. 1 illustrates elements of a preferred electric consumption meter,
Fig. 3 illustrates elements of a preferred electric energy supply system, and
Figs. 3a-3c illustrate different views of selected parts of a switch device embodiment showing a piezo-electric motor element providing a rotational engagement of a mechanical coupling arrangement with mechanical energy storing plate springs, and
Fig. 4 illustrates selected parts of another switch device embodiment with a piezo-electric motor element providing a translational engagement of a mechanical coupling arrangement with mechanical energy storing springs,
Figs. 5a-b illustrate different views of one three-phase power line switch with actuator and mechanical energy storage arrangement mounted in an electric consumption meter housing,
Figs. 6a-b illustrate different views of another three-phase power line switch with actuator and mechanical energy storage arrangement mounted in an electric consumption meter housing, and
Fig. 7 illustrates a block diagram of a preferred electric consumption meter.

### Detailed description of the invention

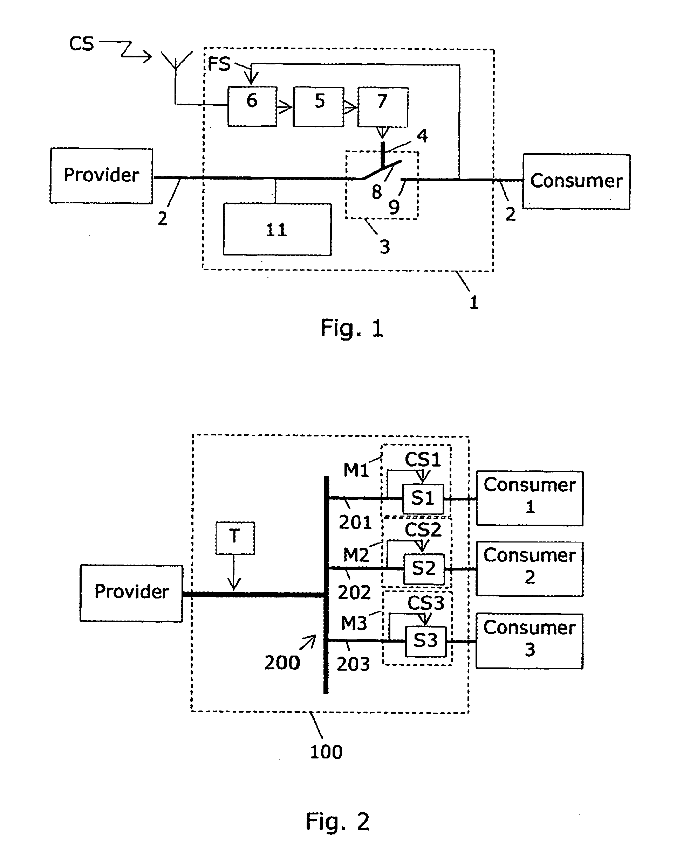

Fig. 1 illustrates schematic elements of a preferred electric consumption meter 1 including a power line switch 3 inserted in an electric power line 2 connecting an electrical energy provider and a consumer. The power line switch 3 of the meter 1 is arranged to receive a control signal CS, e.g. sent from the provider, and to disconnect the power line 2 in response to the control signal CS, thus breaking the supply of electric power to the consumer. An electric energy measuring device 11 is illustrated connected to the power line 2. As indicated in Fig. 1, all elements 3, 5, 6, 7 and 11 are preferably all housed within one common casing of the electric consumption meter 1.

The power line switch 3 includes an electric switch with contact members 8, 9, the switch 3 being inserted in the power line 2 so as to break the electric supply to the consumer when the control signal CS is received. The switch 3 is a two-state switch, i.e. it can be in an "on" state where the contact members 8, 9 establish electrical contact, and an "off" state where the contact members 8, 9 disconnect the electrical contact. The switch 3 state is changed by moving a switch member 4 from one position to another, thus serving to engage with the contact member 8, 9 so as to a change switch state. E.g. the switch member 4 may be in direct mechanical connection with one switch member 8 as illustrated in Fig. 1, or the switch member 4 may be an integrated part of the switch member 8. In general, any type of switch 3 may be used, provided it is capable of handling the electric power required by the particular consumer.

An actuator 5, e.g; an electro-motor, serves as actuator for the switch member 4 via a mechanical energy storage arrangement 7, i.e. the actuator 5 actuates the switch member 4 and thus causing the switch 3 to change switch state. The mechanical energy storage arrangement 7 serves to convert a repeated motion of the actuator 5 to a motion required to move the switch member 4 to change switch state. E.g. the mechanical converter 7 may be arranged to convert a rotational motion of a rotating electro-motor 5 to a required translational movement of the switch member 4 to cause a change of switch state. The mechanical energy storage arrangement is capable of storing mechanic energy produced by the motor 5 and release it in a fast movement so as to ensure that a rather weak motor 5 can produce mechanic energy to provide a fast actuation of the contact members 8, 9 without the risk of causing any sparks between the contact members 8, 9 due to their mutual distance being too small.

In Fig. 1 the actuator is driven by a drive circuit 6 that receives the control signal CS and generates an electric drive signal causing the motor 5 to actuate the switch 3. Preferably, the drive circuit 6 is capable of receiving both an "on" and "off" control signal CS, and the actuator 5 may be capable of operating bi-directionally such that it can move in one direction to actuate the switch 3 to "on" state and in the opposite direction to actuate the switch 3 to "off" state. Most often the drive circuit 6 is dedicated to the specific actuator 5, e.g. in case of a piezo-electric motor type, since the drive signals must be specifically suited to the mechanic structure of the actuator.

In Fig. 1 an optional feedback signal FS is used to sense if the power line 2 to the consumer is actually connected or not, i.e. to indirectly indicate if the power switch 3 is "on" or "off". Thus, such feedback signal FS allows the drive circuit 6 to operate the actuator 5 in response to an actual state of the switch 3, e.g. cut off the drive signal once the desired switch state is obtained. Such feedback signal FS may be used for operation of the drive circuit 6 both in case of a uni-directional motor 5 and a bi-directional motor 5. In Fig. 1 the feedback signal FS is taken from the power line 2 on the consumer side of the switch 3, the feedback signal FS may also be obtained as a voltage across the switch 3, i.e. the drive circuit 6 may use a voltage difference across the switch 3 as feedback signal FS indicating the actual state of the switch 3.

It is appreciated that such feedback signal FS indicating the state of the switch 3 may be obtained in a large variety of ways, including direct a low voltage signal applied to an additional low voltage switch arranged to mechanically sense the actual state of the power switch 3, e.g. the low voltage switch may be mechanical contact positioned to change state in response to the contact member 4 moves from one state to the other. If power switches 3 are mounted on each electrical phase of the power line 2, separate feedback signals FS indicating the state of each power switch 3 may be provided, e.g. also including a feedback signal FS indicating the state of a power switch 3 for the neutral conductor. It may be preferred to transmit the feedback signal FS to the provider in order to indicate if the switch 3 has responded properly to the control signal CS, and if not, the provider can take action accordingly. E.g. the switch 3 may be damaged and is therefore not able to disconnect the power line 2, with the feedback signal FS the provider is informed that the switch device 1 has not responded properly and can take according action.

The feedback signal FS may be indirectly applied to the drive circuit 6, e.g. via a central microprocessor controlling the electric consumption meter 1. Still further, the drive circuit 6 may share power supply with measuring circuits of the electric meter, and the drive circuit 6 may even be completely integrated with the electronic circuits of the electric meter.

It may be preferred to use as actuator 5 a uni-directional piezo-electric motor, i.e. a motor configured for one movement direction, preferably combined with the above-mentioned feedback signal FS. Such uni-directional motor can be implemented with a simple drive circuit 6. However, in case such feedback is not implemented, it may be preferred to provide embodiments with a bi-directional motor where a first motor direction changes the switch state from the first to the second state, while a second motor direction changes the switch state from the second to the first direction.

It is preferred that the provider can send the control signal CS to disconnect a consumer power line remotely, e.g. by a wireless radio communication such as indicated in Fig. 1. However, this can also be obtained by communication via a dedicated wire or via the power line 2, e.g. as a low level high frequency signal overlaid the power voltage.

The actuator 5, the mechanical energy storage arrangement 7 and the switch 3 including switch member 4 may be implemented such that they form one integrated unit within the electric consumption meter 1, e.g. housed within one common casing. The drive circuit 6 may further be included in such integrated unit, or the drive circuit 6 may be integrated with other circuit elements of the electric consumption meter 1.

Fig. 2 illustrates an electric supply system 100 for supply or distribution of electric energy to a number of consumers 1, 2 and 3 from a provider 1 via a net 200 of electric power lines 201, 202, 203. The system 100 includes for each consumer an electric consumption meter M1, M2, M3 with a power line switches S1, S2, S3 mounted on power lines supplying electric energy to each of the consumers 1, 2 and 3, S1, S2 and S3 can each disconnect more phases and/or a neutral conductor. The switch devices S1, S2, S3 can be individually controlled via respective control signals CS1, CS2, CS3 thus enabling the provider to disconnect the electric energy supply to the consumers 1, 2, and 3 independently. In the illustrated embodiment, the control signals CS1, CS2, CS3 are sent from a remotely located transmitter T connected to the supply net 200, while the switch devices S1, S2, S3 are connected to receive the control signals CS1, CS2, CS3 from the power lines 201, 202, 203, e.g. in form of RF signals overlaid the supply power voltage. The provider may access the individual switches using control signals CS1, CS2, CS3 with individual codes for accessing the corresponding switch device S1, S2, S3.

Many different types of actuators capable of providing a plurality of repeated movements can be used such as rotational electro-motors. Very compact low cost and low power miniature electro-motor and gearbox assemblies are available that can deliver the required mechanical energy to actuate a power line switch, or even three or four power line switches at the same time.

However, one class of motors is particularly suited, namely piezo-electric motors, since such motors can be implemented without any magnetic materials, and thus its function is completely immune to strong magnetic fields. Further, commercially available piezo-electric miniature motors are characterized by a large amount, e.g. in the order 100.000, of small repeated movements to provide the mechanical energy required motion to actuate a power line switch. Typically, piezo-electric motors do not produce the same amount of mechanical energy as do corresponding miniature conventional electro-motors, however their main advantage is their magnetic immunity. Many types of piezo-electric motors are available, and a few examples will be given in the following.

WO 2005/043739 by Piezomotor Uppsala AB, describes a translational type motor that generates a translational or linear movement by a peristaltic electromechanical (piezo-electric) actuating element arranged against a body. The actuating element is built of sections of piezo-electric elements arranged for selectively causing a dimension change in a direction of motion within a limited section of the actuating element. By changing voltage signals activating the limited section, the limited section is caused to move along the actuating element, thereby displacing the body relative to the actuating element, thus generating a translational or linear movement.

US 6,940,209 by New Scale Technologies, describes a motor for driving a threaded shaft engaged with a threaded nut. A piezo-electric element is used to generate ultrasonic vibrations (i.e. with a frequency of 20 kHz or greater) and subject the nut to the ultrasonic vibrations. Thereby the nut causes the threaded shaft to simultaneously rotate and translate in its axial direction through the nut.

US 6,437,485 by Piezomotor Uppsala AB, describes different types of piezo-electric motors based on displacement elements with two piezo-electric elements interconnected by a passive part. Each of the two piezo-electric elements includes a bimorph, where the active volumes extend in parallel out from the passive part. Rotational and translational embodiments are disclosed based on such displacement elements.

EP 1 520 338 by Elliptec Resonant Actuator AG, describes a piezo-electric motor with a piezo-electric element connected to a vibrating member with a tip performing a repeated elliptical movement, this elliptical movement of the tip being capable of transferring mechanical energy via friction to e.g. a wheel, a rod etc. Embodiments with use of this type of piezo-electric motor will be described in the following.

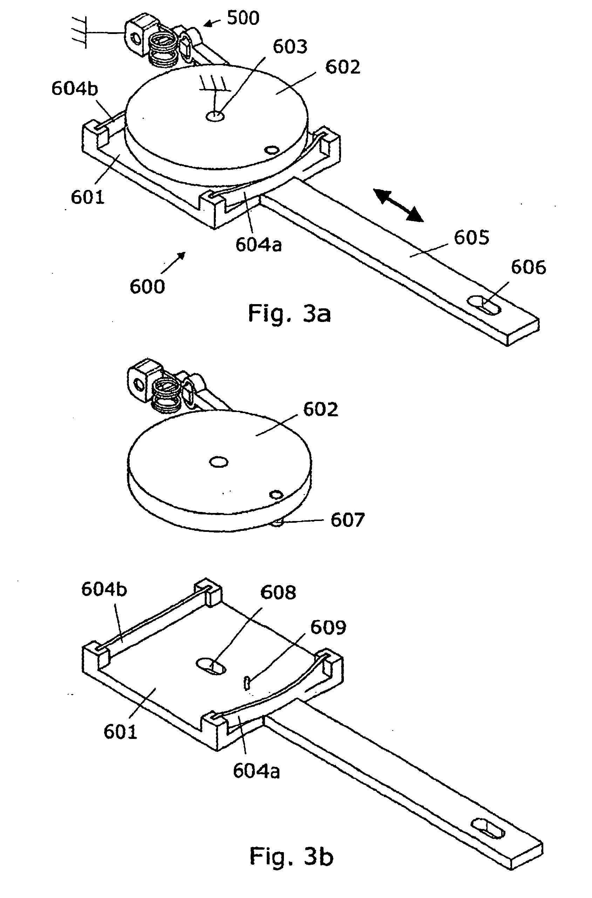

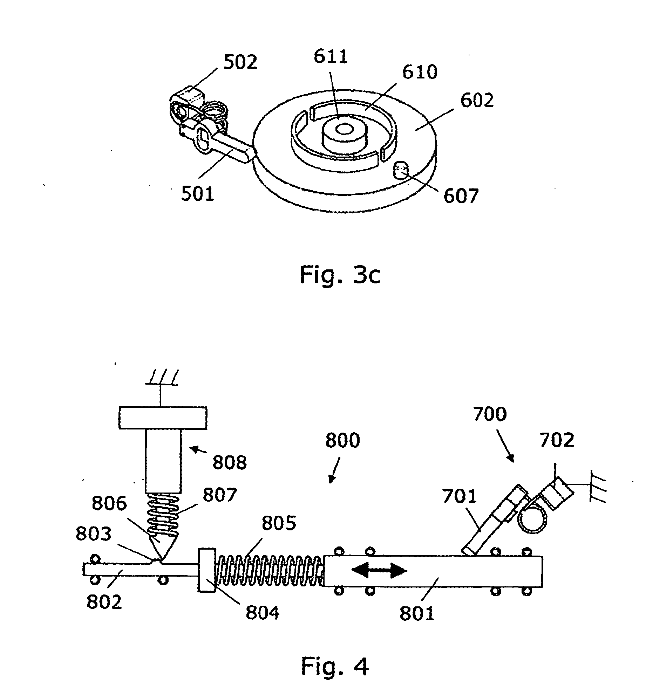

Figs. 3a, 3b and 3c illustrate different views of parts of an embodiment where the piezo-electric motor 500 from Elliptec Resonant Actuator AG as mentioned above, acts as actuator that provides an elliptic type of rotational motion, and a mechanical energy storage arrangement 600 converts the motion of the piezo-electric motor 500 and provides a translational movement in the directions indicated by the bold bi-directional arrow so as to engage with a switch member of a power switch (not shown). In Fig. 3a the selected parts of motor 500 and mechanism 600 are shown in an assembled state, while Fig. 3b illustrates the parts dismantled. Fig. 3c shows a different view of one selected part to show details of the mechanism which are hidden on the view shown in Figs. 3a and 3b.

Referring to Figs. 3a, 3b and 3c the function of the embodiment will now be described. A piezo-electric motor element 500 produces mechanical energy by motion of a moving member 501 relative to a fixed part 502 that is intended for attachment to a fixed part (not shown) of the switch device. The basic function principle is that the piezo-electric motor 500 engages with a mechanical energy storage arrangement 600 such that it moves a movable member including a base part 601 and a rod 605 with a hole 606 for attachment to a not shown switch member of a power switch. The arrangement 600 converts a rotational movement of a disc member 602 to a bi-directional movement of the movable member 601, 605, while mechanical energy is stored in blade springs 604a, 604b and released so as to provide a snap movement of the movable member 601, 605 in response to the mechanical energy produced by the piezo-electric motor 500.

During function, the moving member 501 performs a vibrating movement and engages with an outer surface of a disc member 602 rotationally mounted with an axle 603, such that the moving member 501 causes the disc member 602 to rotate around axle 603 which is fixed to the not shown fixed part of the switch device. The tip of the moving member 501 of the motor 500 performs a repeated, small elliptic movements, and in preferred embodiments each repeated movement only contributes to a small angular movement of the disc member 602 such that more than 100.000 repeated movements are involved to switch state of the switch.

The motor 500 may be electrically controllable such that it is possible to rotate the disc member 602 both clockwise and anti-clockwise. However, the mechanical coupling arrangement 600 is adapted to move the movable member 601, 605 forth and back for each full rotation of the disc member 602, and thus on/off switching is possible with only one moving direction of the motor 500.

The axle 603 goes through a hole 608 in the base part 601, the hole 606 being shaped such as to fix the movable part 601, 605 relative to the disc member 602 in a direction perpendicular to the moving direction indicated by the bi-directional bold arrow. In a direction along the moving direction, the hole 608 is shaped such as to allow the moving part 601, 605 to move relative to the disc member 602 in the moving direction.

Two blade springs 604a, 604b are fixed to the base part 601 opposite each other such that they, in turn, are engaged by a spring engaging pin 607 on one side of the disc member 602, as the disc member 602 rotates. Thereby the blade springs 604a, 604b serve to collect mechanical energy during at least part of the rotational movement. In Figs. 3a and 3b the device is illustrated in a position of the disc member 602 where blade spring 604a bent and thus in a state where a maximum of mechanical energy is stored therein due to bending. In this position, the movable member 601, 605 is kept in a fixed position relative to the disc member 602 in the movable direction via a protruding pin 609 mounted on the base part 601, the pin 609 engaging with a circular protrusion 610 on the disc member 602. The circular protrusion 601 has two openings corresponding to the circular position of the spring engaging pin 607 and 180° opposite thereto, the openings being shaped to allow the pin 609 to pass the circular protrusion 610 and thereby release the movable member 601, 605 to move in the movable direction relative to the disc member 602. Since this release coincides with a maximum tension of one of the blade springs 604a, 604b caused by the angular position of the spring engaging pin 607, the movable member 601, 605 will be released in a snap-like manner and thus perform a fast movement in one of the movable directions. The displacement of the movement is determined by the length of the hole 608 in the movable direction, among other parameters. Preferably, such displacement is arranged such that is allows contact members in the power switch to have a mutual distance of at least 1-3 mm in the off position, and thus the actual displacement of the rod 605 should be suited to provide this distance, either by engaging with a switch member of the switch being in direct contact with one contact member, such as the rod 605 directly engaging with one movable contact member of the switch.

In the angular position of the disc member 602 shown in Figs. 3a and 3b, the release will occur once the disc member 602 is rotated slightly clockwise. If further rotated, a movement of the movable member 601, 605 will be released in the opposite direction after yet another 180° of rotation, since spring engaging pin 607 has then built up mechanical energy due to bending of blade spring 604b.

The spring engaging function of pin 607 can alternatively be obtained by a circular protrusion on the disc member 602 in the same manner as protrusion 610. Such circular protrusion preferably has a varying thickness with a maximum corresponding to the angular position of pin 607. With a gradual varying thickness instead of pin 607, it is possible to provide a more gradual engaging of the spring 604a, 604b during a large part of a full rotation, and thereby provide a more steady varying load of the motor 500 during a full rotation of the disc member 602. Further, with the pin 607 replaced by a circular protrusion, it is possible to form all of parts 602, 610, 611 and 607 by one monolithic body.

The not shown fixed part of the switch device may be a separate casing around the switch device, or this fixed part may be formed by a part of another device, e.g. a casing or another part of an electric consumption meter. It is appreciated that the basic function of the arrangement shown in Figs. 3a-3c can be obtained with a larger variety of implementation configurations, e.g. the disc member 602 may have a different shape than circular, e.g. elliptical, so as to provide a build up of mechanical energy in the blade springs 604a, 605b on a larger angular part of the rotation than with the shown circular shape, thus allowing a weaker motor 500 to deliver the necessary mechanical energy.

The movable parts 601, 605 may be formed by a polymeric material or a metal, however other types of materials can be used, e.g. glass or ceramic materials. The blade springs 604a, 604b, the pins 607 and 609 and axle 603 are preferably formed by metal, while the disc member 602 is preferably formed by a polymeric material but it may alternatively be formed by metal, e.g. aluminium. It may be preferred to form all of or at least most of the parts in electrically non-conducting materials, especially in case the parts are located near the electric high voltage conductors or neutral.

Fig. 4 illustrates another mechanical coupling arrangement 800 activated by a piezo-electric motor 700. The piezo-electric motor 700 may in principle be the same type as the motor 500 illustrated in Fig. 3, however in the configuration illustrated in Fig. 4 the motor 700 has a moving member 701 engaging with an engager rod 801 causing the engager rod 801 to perform a translational or linear movement in a movable direction indicated by the bi-directional bold arrow.

A fixed part 702 of the motor 700 is fixed to a not shown fixed part of the switch device. The small circles indicate bearings that are also understood to be fixed to a not shown fixed part of the switch device and these bearings serve to fix movements of the engager rod 801 and an actuating rod 802 in the movable direction. The actuating rod 802 is intended for engaging contact members of the switch, either directly or via a switch member. A helical engager spring 805 serves to collect mechanical energy as the motor 700 causes the engager rod 801 to move, since the engager spring 805 is fixed to the engager rod 801 in one end and to a part 804 fixed to the actuating rod 802 in its opposite end. In the shown embodiment the engager spring 805 extends around one end of the actuating rod 802, and this end of the actuating rod 802 extends inside the helical spring and to a hollow inner part of the engager rod 801.

To provide a sudden release of the actuating rod 802, a release mechanism is provided that serves to engage with a protrusion 803 on the actuating rod 802. A release pin 806 is fixed to one end of a helical release spring 807. The opposite end of the release spring 807 is fixed to a part 808 mounted fixed to a not shown part of the switch device. In the illustrated embodiment, the release pin 806 is movable in a direction perpendicular to the movable direction of the actuating rod 802. Since the release pin 806 is forced towards the actuating rod 802 due to a compression of the release spring 807, the protrusion 803 serves to lock the actuating rod 802 in a fixed position until the mechanical energy collected by the engager spring 805 exceeds the force required for the protrusion 803 to pass the release pin 806 and thereby further compress the release spring 807. As this force is exceeded, the protrusion 803 passes the release pin 806 and hence the actuating rod is released and will be forced in the movable direction by the energy stored in the engager spring 805. Thus, a snap-like release of the actuating rod 802 is provided which can be driven by a rather weak piezo-electric motor 700 only capable of slowly building up mechanical energy in the engager spring 805 via engagement of the engager rod 801.

In the position of the arrangement 800 illustrated in Fig. 4, mechanical energy is stored in the engager spring 805 by extension as the motor 700 moves the engager rod 801 towards the right. The protrusion 803 is in contact with the release pin 806 that serves to lock the actuating rod 802 in position until enough mechanical energy is stored in the engager spring 805 to allow the protrusion 803 to press the release pin 806 upwards thus releasing the actuating rod 802 that will then perform a fast movement to the right.

In contrast to the embodiment of Fig. 3, the embodiment of Fig. 4 requires the motor 700 to change direction in order to change direction of the actuating rod 802 and thus change the switch from on to off an vice versa. The materials used to form the various parts of the arrangement 800 may be polymeric materials, metal or other materials such as described for the embodiment of Fig. 3. The springs 805, 807 are preferably formed by metal as well as the actuating rod 802. As described for the embodiment of Fig. 3, the embodiment of Fig. 4 can be mounted either to a separate casing around the switch device, or the parts that need to be fixed may be fixed to a part of another device, e.g. a casing or another part of an electric consumption meter.

For both embodiments shown in Figs. 3 and 4, the possible external influence by a strong magnet is small even though magnetic materials are used for some of the parts, e.g. the springs. The reason is that the use of the piezo-electric motors 500, 700 to produce mechanical energy and the effect of these motors 500, 700 can be made totally immune to magnetic fields. The total function of the arrangements illustrated in Figs. 3 and 4 is only very slightly influenced even by a strong external magnet even though some of the parts are formed by magnetic materials. The reason is that the energy storing and release mechanisms serve to convert small movements of the single moving parts to a sudden release that will easily overcome an external force applied to them by a strong external magnet.

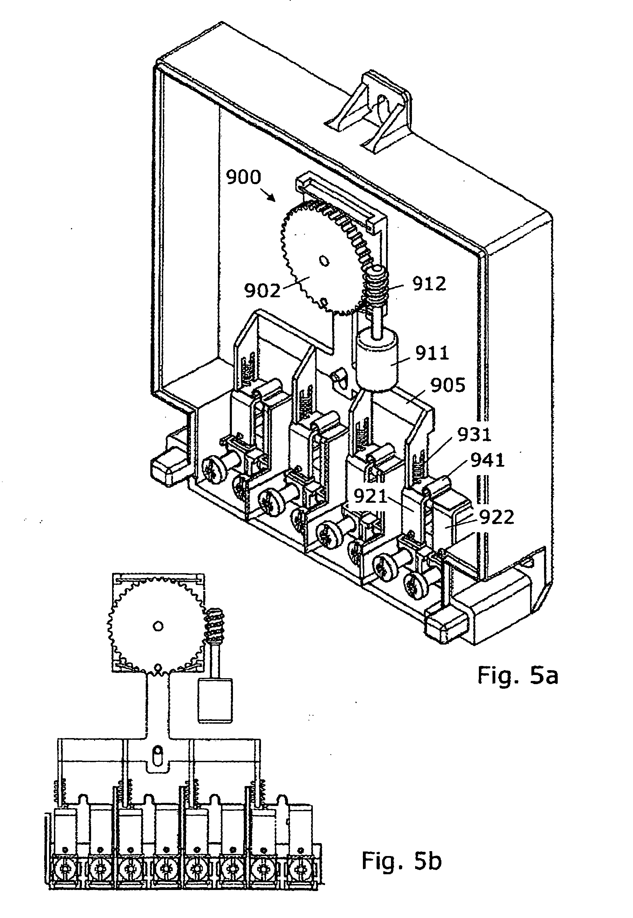

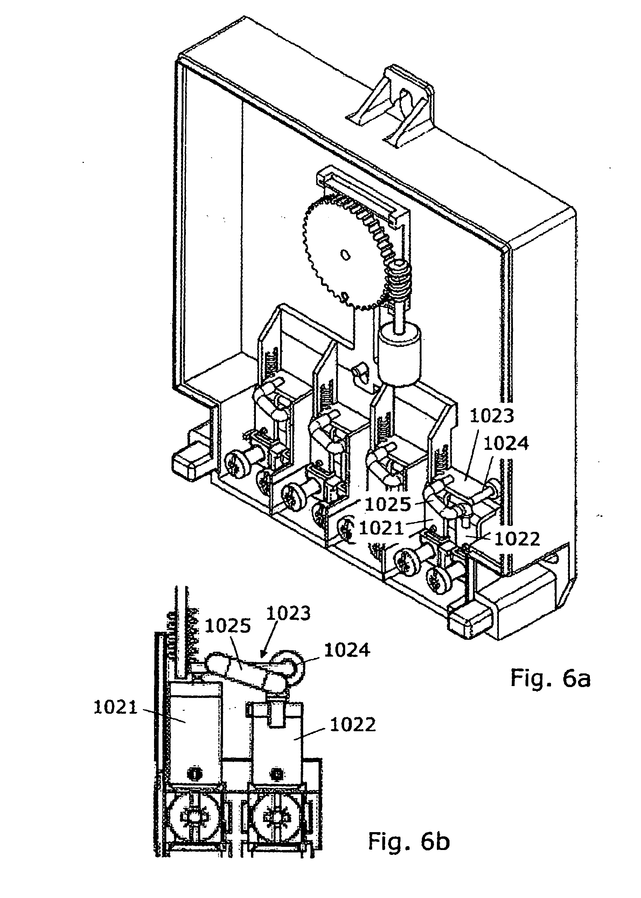

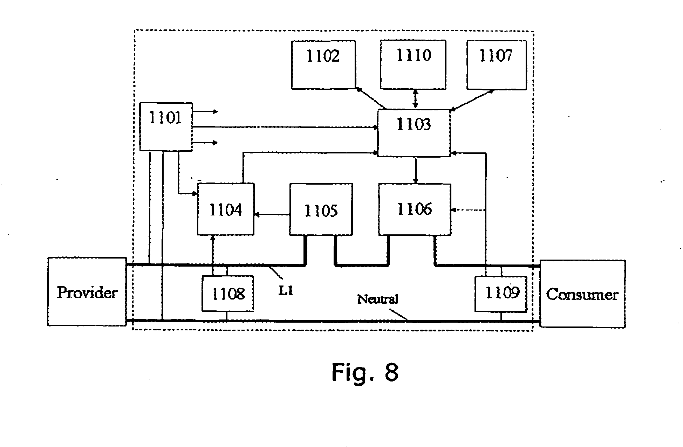

Figs. 5 and 6 illustrate two electric consumption meter embodiments with their fronts and electronic circuit elements removed so as to illustrate actuator, mechanical energy storage arrangement and power line switches mounted on a rear panel within the meter housing. This position of especially the actuator is advantageous since the meter is arranged for mounting with its rear panel on a wall. Thus, since the actuator is placed on the rear panel, it has the longest possible distance, within the casing, to consumer accessible parts of the casing. Thereby, it is least possible influences by an external magnet, since the distance between an external magnet and the actuator will be rather large resulting in a small magnetic field influencing the actuator. It may even be possible to provide a magnetic sealing around the actuator to further reduce magnetic influence.

Both embodiments of Figs. 5 and 6 have the same type of actuator and mechanical energy storage arrangement 900, and they both include four power line switches serving to disconnect three phases and a neutral conductor. Both embodiments are based on a miniature electro-motor package 911 including a miniature electro-motor and optionally a gear box. The embodiments in Figs. 5 and 6 differ with respect to the configuration of the power line switches. Thus, the description of actuator and mechanical energy storage arrangement 900 will only be explained with reference to Fig. 5, but the same description applies to the embodiment of Fig. 6 as well.

Fig. 5a shows a 3D view of the arrangement 900 mounted within the meter housing, while Fig. 5b shows a front view of the arrangement 900 and switches only. In Fig. 5 the mechanical energy storage arrangement 900 basically corresponds to that illustrated and described in connection with Fig. 3, and thus the description of its function above therefore applies as well to Figs. 5 and 6. However, the disc 602 is replaced by a tooth wheel 902 which is actuated by the electro-motor package 911 via a threaded spindle 912 engaging with the tooth wheel 902. The rod 605 is replaced by a fork shaped rod 905 with one rod portion to engage with each of the four power line switches.

A spring 931 is mounted between the rod 905 and the switch member 941, this spring serves to apply a force on the switch member 941 in the "on" state so as to ensure a desired force between contact points of the switch and thereby provide a low electric resistance between the mounting sockets 921, 922 serving to connect to input and output wires for each phase and for neutral. Further, the spring 931 serves to absorb production tolerances that would otherwise cause function problems in case the rod 905 and switch member 941 were rigidly connected.

It may be preferred to arrange the actuation mechanism such that power line switches for the three phases and neutral are not actuated simultaneously but offset by a few ms. This can e.g. be obtained by using springs 931 with different spring constants for phases that should not have their switches actuated at the same time.

The switch member 941 that provides the electrical connection between the sockets 921, 922 in the "on" state is preferably formed from a sheet of cupper and provided with a bend such that it capable of performing the required switch movement without fatigue problems, and at the same time without requiring a large force from the actuation mechanism.

Fig. 6a shows a 3D view similar to Fig. 5a but with an alternative switch mechanism. Fig. 6b shows a close-up front view of the switch mechanism. In this switch embodiment, the actuation rod engages a "hinged door" mechanism 1023, 1024. However, only a small part of the "door" 1023 acts as electrical conductor between sockets 1021, 1022. The "door" 1023 is preferably made of cupper, but other metals can be used. The "door" 1023 is electrically connected to the socket 1022 via a conductor member 1025 preferably being a plurality of thin wires, preferably cupper, plaited together. One end of the conductor member 1025 is connected to the "door" 1023 while the other end is connected to the socket 1022. Such arrangement provides a flexible connection while such conductor 1025 can still have a considerable cross sectional area and thus exhibit a low electrical resistance.

Fig. 7 shows a block diagram of elements in a preferred electric consumption meter connected to one phase L1 and neutral conductor of a power line that interconnects a provider and a consumer. A voltage supply 1101 supplies voltage to power requiring circuits of the meter, e.g. to microprocessor 1103 serving as energy calculator, and to power calculation unit 1104. The power calculation unit 1104 receives data from a current measurement unit 1105 and a voltage measurement unit 1108, and provides the microprocessor 1103 with a calculated power value. The microprocessor 1103 is connected to a display 1102, a communication unit 1107, e.g. a radio module, and an interface module 1110, e.g. including buttons, LEDs, switch output S0 pulses etc.

The power line switch arrangement 1106 is shown inserted in the L1 phase of the power line, and a voltage detector 1109 provides a feedback signal to either or both of microprocessor 1103 and power line switch arrangement 1106, such that it is possible for the microprocessor 1103 to control the switch arrangement 1106 accordingly.

In further embodiments of the electric consumption meter, more power line switches may be included. Preferably, such switches have actuator and mechanical energy storage arrangements similar to the ones described above. Such further power line switches can e.g. be used to connect or disconnect power consuming electric equipment in response to parameters from outside, e.g. parameters received by a bullt-in communication module. E.g. such outside parameters may be time-varying tariffs charged by the electric energy provider, such that power consuming equipment is started in low-tariff periods only.

To sum up the invention: an electric consumption meter with a power line switch is provided. The switch either connects or disconnects an electric power line. An actuator, e.g. a small electro-motor or a piezo-electric motor, is arranged to actuate change state of the switch in response to a control signal. A mechanical energy storage arrangement connects the actuator and the switch member. Actuation of the switch member involves a plurality of repeated movements of at least one part of the actuator. The switch function of the meter is insensitive to influence of strong magnetic fields even in case e.g. an electro-motor is used as actuator. However, using a piezo-electric motor as actuator results in a completely magnetically immune switch function. Further, a small and weak actuator can be used and still provide mechanical energy to drive e.g. four switches, one for each of three electrical phase and one for neutral, and still provide a reliable switch function with force enough to provide a low "on" resistance of the switch, and to provide a quick switch function avoiding sparks. Preferably, the actuator, switch and mechanical energy storage arrangement are located within a casing of the meter, most preferably it is located with the largest possible distance to consumer accessible surfaces of the casing. The meter preferably has a communication module to receive the control signal, e.g, a wireless RF module. Measured consumed electrical energy data may also be communicated via the communication module.

Although the present invention has been described in connection with the specified embodiments, it is not intended to be limited to the specific form set forth herein. Rather, the scope of the present invention is limited only by the accompanying claims. In the claims, the term "comprising" or "including" does not exclude the presence of other elements. Additionally, although individual features may be included in different claims, these may possibly be advantageously combined, and the inclusion in different claims does not imply that a combination of features is not feasible and/or advantageous. In addition, singular references do not exclude a plurality. Thus, references to "a", "an", "first", "second" etc. do not preclude a plurality. Furthermore, reference signs in the claims shall not be construed as limiting the scope.

## Claims

1. An electric consumption meter (1) for measuring an amount of electrical energy delivered by an electric power line (2), the meter (1) comprising
- a measuring device (11) arranged to measure the amount of electric energy delivered by the electric power line (2), and to generate a data value representing the measured amount of electric energy,
- a power line switch (3) arranged for connecting the electric power line (2) In a first state and for disconnecting the electric power line (2) in a second state, wherein the switch (3) is arranged to switch between the first and second states upon actuation of a switch member (4),
- a communication module (1107) arranged to receive a control signal (CS) from an associated external transmitter,
- an actuator (5) operationally arranged to actuate the switch member (4) in response to the control signal (CS),
**characterised in that** the actuation of the switch member (4) involves a plurality of repeated movements of at least one part of the actuator (5), and
- a mechanical energy storage arrangement (7) connecting the actuator (5) and the switch member (4) to collect mechanical energy produced by the actuator (5) and to release the collected mechanical energy for actuation of the switch member (4).

2. Meter (1) according to claim 1, wherein the actuator includes at least one part performing a plurality of rotations around an axle.

3. Meter (1) according to any of the preceding claims, wherein actuation of the switch member involves a plurality of repeated movements of at least one part of the mechanical energy storage arrangement.

4. Meter (1) according to any of the preceding claims, including a casing for housing the measuring device, the power line switch, the actuator and the mechanical energy storage arrangement.

5. Meter (1) according to claim 4, wherein at least the actuator is located in the casing behind at least one of: user interface and electronic circuits.

6. Meter (1) according to claim 4 or 5, wherein at least the actuator is mounted in a rear part of the casing.

7. Meter (1) according to any of claims 4-6, wherein actuator, power line switch and mechanical energy storage arrangement are attached to a rear panel of the casing.

8. Meter (1) according to any of the preceding claims, wherein the actuator includes a piezo-electric motor.

9. Meter (1) according to the preceding claims, wherein the actuator includes an electromagnetic motor.

10. Meter (1) according to any of the preceding claims, wherein the actuator is capable of moving In two directions.

11. Meter (1) according to claim 10, wherein the actuator is capable of actuating the switch member In a first movement direction so as to switch from the first state to the second state, and further capable of actuating the switch member In a second movement direction so as to switch from the second state to the first state.

12. Meter (1) according to any of the preceding claims, wherein the mechanical energy storage arrangement includes a spring member serving to collect mechanical energy produced by the actuator.

13. Meter (1) according to any of the preceding claims, wherein the actuator is connected to actuate the switch member via a threaded spindle.

14. Meter (1) according to any of the preceding claims, wherein the actuator Is connected to actuate the switch member via a toothed wheel arrangement.

15. Meter (1) according to any of the preceding claims, including a power supply for delivering power for operation of the measuring device and the actuator.

16. Meter (1) according to any of the preceding claims, wherein a feedback signal representing the state of the switch is applied to a drive circuit controlling the actuator in response to the control signal.

17. Meter (1) according to claim 16, wherein the feedback signal is provided based on an electric measurement performed on the power line.

18. Meter (1) according to claim 16 or 17, wherein the feedback signal is provided based on detection of a position of a mechanical part of the switch.

19. Meter (1) according to any of claims 16-18, wherein the feedback signal and the control signal are applied to a microprocessor serving to control the actuator in response to the control signal.

20. Meter (1) according to claim 19, wherein the microprocessor is part of the measuring device of the meter.

21. Meter (1) according to any of the preceding claims, including a plurality of power line switches (3) arranged to disconnect respective electric phases of the power line (2) in response to the control signal (CS).

22. Meter (1) according to claim 21, wherein the plurality of power line switches (3) are actuated by one common actuator.

23. Meter (1) according to claim 21, wherein the plurality of power line switches (3) are actuated by respective actuators.

24. Meter (1) according to any of claims 21-23, including a power line switch (3) arranged to disconnect a neutral conductor of the power line (2) in response to the control signal (CS).

25. Meter (1) according to claim 1, wherein the communication module (1107) is further arranged to transmit the data value representing the measured amount of electric energy to an associated external receiver.

26. Meter (1) according to claim 1 or 25, wherein the communication module (1107) is arranged to transmit data representing the state of the power line switch (1106) to an associated external receiver.

27. Meter (1) according to any of claims 1 or 25 or 26, wherein the communication module (1107) is arranged to communicate via wireless Radio Frequency signals.

28. Meter (1) according to any of claims 1 or 25-27, wherein the communication module (1107) is arranged to communicate via the electric power line (2).

29. Meter (1) according to any of claims 1 or 25-28, wherein the communication module (1107) is arranged to communicate via a dedicated communication wire.

30. Supply system (100) for supply of electric energy to a plurality of associated consumers via a net (200) of electric power lines (201, 202, 203), the system including
- a plurality of electric consumption meters (M1, M2, M3) according to any of claims 1 or 23-29, the meters (M1, M2, M3) being arranged to disconnect respective electric power lines (201, 202, 203) supplying electric energy to each of the associated consumers upon receiving respective control signals (CS1, CS2, CS3), and
- a transmitter (T) arranged to transmit respective control signals (CS1, CS2, CS3) to the plurality of electric consumption meters (M1, M2, M3) so as to disconnect electric energy supply to the respective associated consumers.

31. System (100) according to claim 30, wherein the transmitter (T) and the electric consumption meters (M1, M2, M3) are arranged to communicate the control signals (CS1, CS2, CS3) In a wireless Radio Frequency representation.

32. System (100) according to claim 30 or 31, wherein the transmitter (T) and the electric consumption meters (M1, M2, M3) are arranged to communicate the respective control signals (CS1, CS2, CS3) via the net (200) of electric power lines (201, 202, 203).

33. System (100) according to any of claims 30-32, wherein the transmitter (T) and the electric consumption meters (M1, M2, M3) are arranged to communicate the respective control signals (CS1, CS2, CS3) via a dedicated communication wire.

## Patentansprüche

1. Elektrischer Verbrauchsmesser (1) zum Messen der Menge an elektrischer Energie, die von einer Stromleitung (2) abgegeben wird, wobei der Messer (1) umfasst
- eine Messvorrichtung (11), die derart eingerichtet ist, dass die Menge an elektrischer Energie, die von einer Stromleitung (2) abgegeben wird, gemessen und ein Datenwert erzeugt wird, der die gemessene Menge an elektrischer Energie darstellt,
- einen Netzschalter (3), der derart eingerichtet ist, dass die Stromleitung (2) in einem ersten Zustand verbunden und die Stromleitung (2) in einem zweiten Zustand unterbrochen wird, wobei der Schalter (3) derart eingerichtet ist, dass er nach Betätigen eines Schaltglieds (4) zwischen dem ersten und dem zweiten Zustand hin- und herschaltet,
- ein Kommunikationsmodul (1107), das derart eingerichtet ist, dass es ein Steuersignal (CS) von einem damit verbundenen externen Sender empfängt,
- ein Stellglied (5), das funktionstechnisch derart eingerichtet ist, dass es das Schaltglied (4) als Reaktion auf das Steuersignal (CS) betätigt,
**dadurch gekennzeichnet, dass** die Betätigung des Schaltglieds (4) mehrere wiederholte Bewegungen mindestens eines Teils des Stellglieds (5) beinhaltet und
- eine Speicheranordnung für mechanische Energie (7), die das Stellglied (5) und das Schaltglied (4) miteinander verbindet, zum Akkumulieren von mechanischer Energie, die von dem Stellglied (5) erzeugt wird, und zum Freisetzen der akkumulierten mechanischen Energie zum Betätigen des Schaltglieds (4).

2. Messer (1) nach Anspruch 1, wobei das Stellglied mindestens ein Teil umfasst, das mehrere Rotationen um eine Achse durchführt.

3. Messer (1) nach einem der vorhergehenden Ansprüche, wobei die Betätigung des Schaltglieds mehrere wiederholte Bewegungen mindestens eines Teils der Speicheranordnung für mechanische Energie beinhaltet.

4. Messer (1) nach einem der vorhergehenden Ansprüche, umfassend ein Gehäuse zur Aufnahme der Messvorrichtung, des Netzschalters, des Stellglieds und der Speicheranordnung für mechanische Energie.

5. Messer (1) nach Anspruch 4, wobei sich mindestens das Stellglied hinter mindestens entweder der Benutzerschnittstelle oder den elektronischen Schaltkreisen befindet.

6. Messer (1) nach Anspruch 4 oder 5, wobei mindestens das Stellglied in einem hinteren Teil des Gehäuses montiert ist.

7. Messer (1) nach einem der Ansprüche 4-6, wobei das Stellglied, der Netzschalter und die Speicheranordnung für mechanische Energie an der Rückwand des Gehäuses befestigt sind.

8. Messer (1) nach einem der vorhergehenden Ansprüche, wobei das Stellglied einen piezoelektrischen Motor umfasst.

9. Messer (1) nach den vorhergehenden Ansprüchen, wobei das Stellglied einen elektromagnetischen Motor umfasst.

10. Messer (1) nach einem der vorhergehenden Ansprüche, wobei das Stellglied in der Lage ist, sich in zwei Richtungen zu bewegen.

11. Messer (1) nach Anspruch 10, wobei das Stellglied in der Lage ist, das Schaltglied in einer ersten Bewegungsrichtung zu betätigen, sodass von dem ersten Zustand in den zweiten Zustand geschaltet wird, und weiterhin in der Lage ist, das Schaltglied in einer zweiten Bewegungsrichtung zu betätigen, sodass von dem zweiten Zustand in den ersten Zustand geschaltet wird.

12. Messer (1) nach einem der vorhergehenden Ansprüche, wobei die Speicheranordnung für mechanische Energie ein Federelement umfasst, das zur Akkumulierung von dem Stellglied erzeugter mechanischer Energie dient.

13. Messer (1) nach einem der vorhergehenden Ansprüche, wobei das Stellglied zum Betätigen des Schaltglieds über eine Gewindespindel verbunden ist.

14. Messer (1) nach einem der vorhergehenden Ansprüche, wobei das Stellglied zum Betätigen des Schaltglieds über eine Zahnradanordnung verbunden ist.

15. Messer (1) nach einem der vorhergehenden Ansprüche, umfassend eine Stromversorgung zur Abgabe von Strom zum Betrieb der Messvorrichtung und des Stellglieds.

16. Messer (1) nach einem der vorhergehenden Ansprüche, wobei eine Rückmeldungssignal, das den Zustand des Schalters darstellt, zum Betrieb eines Kreises angelegt wird, der das Stellglied als Reaktion auf das Steuersignal regelt.

17. Messer (1) nach Anspruch 16, wobei das Rückmeldungssignal auf der Grundlage einer an der Stromleitung vorgenommenen elektrischen Messung bereitgestellt wird.

18. Messer (1) nach Anspruch 16 oder 17, wobei das Rückmeldungssignal auf der Grundlage der Erfassung einer Position eines mechanischen Teils des Schalters bereitgestellt wird.

19. Messer (1) nach einem der Ansprüche 16-18, wobei das Rückmeldungssignal und das Steuersignal an einen Mikroprozessor angelegt werden, der zur Regelung des Stellglieds als Reaktion auf das Steuersignal dient.

20. Messer (1) nach Anspruch 19, wobei der Mikroprozessor Teil der Messvorrichtung des Messers ist.

21. Messer (1) nach einem der vorhergehenden Ansprüche, umfassend mehrere Netzschalter (3), die derart eingerichtet sind, dass sie die jeweilige elektrische Phase der Stromleitung (2) als Reaktion auf das Steuersignal (CS) unterbrechen.

22. Messer (1) nach Anspruch 21, wobei die mehreren Netzschalter (3) von einem gemeinsamen Stellglied betätigt werden.

23. Messer (1) nach Anspruch 21, wobei die mehreren Netzschalter (3) von jeweils einem Stellglied betätigt werden.

24. Messer (1) nach einem der Ansprüche 21-23, umfassend einen Netzschalter (3), der derart eingerichtet ist, dass er einen Neutralleiter der Stromleitung (2) als Reaktion auf das Steuersignal (CS) unterbricht.

25. Messer (1) nach Anspruch 1, wobei das Kommunikationsmodul (1107) weiterhin derart eingerichtet ist, dass der Datenwert, der die gemessene Menge an elektrischer Energie repräsentiert, an einen damit verbundenen externen Empfänger gesendet wird.

26. Messer (1) nach Anspruch 1 oder, wobei das Kommunikationsmodul (1107) weiterhin derart eingerichtet ist, dass der Datenwert, der die gemessene Menge an elektrischer Energie repräsentiert, an einen damit verbundenen externen Empfänger gesendet wird.

27. Messer (1) nach einem der Ansprüche 1 oder 25 oder 26, wobei das Kommunikationsmodul (1107) derart eingerichtet ist, dass es über drahtlose Funksignale kommuniziert.

28. Messer (1) nach einem der Ansprüche 1 oder 25-27, wobei das Kommunikationsmodul (1107) derart eingerichtet ist, dass es über die Stromleitung (2) kommuniziert.

29. Messer (1) nach einem der Ansprüche 1 oder 25-28, wobei das Kommunikationsmodul (1107) derart eingerichtet ist, dass es über einen dedizierten Kommunikationsdraht kommuniziert.

30. Versorgungssystem (100) zur Versorgung mehrerer verbundener Verbraucher mit elektrischer Energie über ein Netz (200) von Stromleitungen (201, 202, 203), wobei das System umfasst
- mehrere Stromverbrauchsmesser (M1, M2, M3) nach einem der Ansprüche 1 oder 23-29, wobei die Messer (M1, M2, M3) derart eingerichtet sind, dass die entsprechenden Stromleitungen (201, 202, 203), die jeden der verbundenen Verbraucher mit elektrischer Energie versorgen, nach Empfang des jeweiligen Steuersignals (CS1, CS2, CS3) unterbrochen werden, und
- einen Sender (T), der derart eingerichtet ist, das das jeweilige Steuersignal (CS1, CS2, CS3) an die mehreren Stromverbrauchsmesser (M1, M2, M3) gesendet wird, um die Versorgung mit elektrischer Energie des jeweiligen verbundenen Verbrauchers zu unterbrechen.

31. System (100) nach Anspruch 30, wobei der Sender (T) und die Stromverbrauchsmesser (M1, M2, M3) derart eingerichtet sind, dass die Steuersignale (CS1, CS2, CS3) in Form von drahtlosen Funksignalen weitergegeben werden.

32. System (100) nach Anspruch 30 oder 31, wobei der Sender (T) und die Stromverbrauchsmesser (M1, M2, M3) derart eingerichtet sind, dass die Steuersignale (CS1, CS2, CS3) über das Netz (200) an Stromleitungen(201, 202, 203) weitergegeben werden.

33. System (100) nach einem der Ansprüche Anspruch 30-32, wobei der Sender (T) und die Stromverbrauchsmesser (M1, M2, M3) derart eingerichtet sind, dass die jeweiligen Steuersignale (CS1, CS2, CS3) über einen dedizierten Kommunikationsdraht weitergegeben werden.

## Revendications

1. Compteur de consommation électrique (1) destiné à mesurer une quantité d'énergie électrique fournie par une ligne d'alimentation électrique (2), le compteur (1) comprenant
- un dispositif de mesure (11) disposé pour mesurer la quantité d'énergie électrique fournie par la ligne d'alimentation électrique (2) et pour générer une valeur de donnée représentant la quantité mesurée d'énergie électrique,
- un commutateur de ligne électrique (3) disposé pour connecter la ligne d'alimentation électrique (2) dans un premier état et pour déconnecter la ligne d'alimentation électrique (2) dans un deuxième état, où le commutateur (3) est disposé pour alterner entre le premier et le deuxième état lors de l'actionnement d'un élément de commutateur (4),
- un module de communication (1107) disposé pour recevoir un signal de commande (CS) provenant d'un transmetteur externe associé,
- un actionneur (5) disposé opérationnellement pour actionner l'élément de commutateur (4) en réponse au signal de commande (CS), **caractérisé en ce que** l'actionnement de l'élément de commutateur (4) fait intervenir une pluralité de mouvements répétés d'au moins une pièce de l'actionneur (5), et
- un système de stockage d'énergie mécanique (7) connectant l'actionneur (5) et l'élément de commutateur (4) pour collecter l'énergie mécanique produite par l'actionneur (5) et pour restituer l'énergie mécanique collectée pour l'actionnement de l'élément de commutateur (4).

2. Compteur (1) selon la revendication 1, dans lequel l'actionneur inclut au moins une pièce effectuant une pluralité de rotations autour d'un axe.

3. Compteur (1) selon l'une quelconque des revendications précédentes, dans lequel l'actionnement de l'élément de commutateur fait intervenir une pluralité de mouvements répétés d'au moins une pièce du système de stockage d'énergie mécanique.

4. Compteur (1) selon l'une quelconque des revendications précédentes, incluant un boîtier pour loger le dispositif de mesure, le commutateur de ligne électrique, l'actionneur et le système de stockage d'énergie mécanique.

5. Compteur (1) selon la revendication 4, dans lequel au moins l'actionneur est situé dans le boîtier derrière l'un au moins des éléments suivants : interface utilisateur et circuits électroniques.

6. Compteur (1) selon la revendication 4 ou 5, dans lequel au moins l'actionneur est monté dans une pièce arrière du boîtier.

7. Compteur (1) selon l'une quelconque des revendications 4 à 6, dans lequel l'actionneur, le commutateur de ligne électrique et le système de stockage d'énergie mécanique sont fixés sur un panneau arrière du boîtier.

8. Compteur (1) selon l'une quelconque des revendications précédentes, dans lequel l'actionneur inclut un moteur piézoélectrique.

9. Compteur (1) selon les revendications précédentes, dans lequel l'actionneur inclut un moteur électromagnétique.

10. Compteur (1) selon l'une quelconque des revendications précédentes, dans lequel l'actionneur est capable de se mouvoir dans deux directions.

11. Compteur (1) selon la revendication 10, dans lequel l'actionneur est capable d'actionner l'élément de commutateur dans une première direction de mouvement de manière à passer du premier état au deuxième état, et également capable d'actionner l'élément de commutateur dans une deuxième direction de mouvement de manière à passer du deuxième état au premier état.

12. Compteur (1) selon l'une quelconque des revendications précédentes, dans lequel le système de stockage d'énergie mécanique inclut un élément de ressort servant à collecter l'énergie mécanique produite par l'actionneur.

13. Compteur (1) selon l'une quelconque des revendications précédentes, dans lequel l'actionneur est connecté pour actionner l'élément de commutateur par l'intermédiaire d'une broche filetée.

14. Compteur (1) selon l'une quelconque des revendications précédentes, dans lequel l'actionneur est connecté pour actionner l'élément de commutateur par l'intermédiaire d'un système à roue dentée.

15. Compteur (1) selon l'une quelconque des revendications précédentes, incluant une alimentation électrique pour fournir de l'électricité pour le fonctionnement du dispositif de mesure et de l'actionneur.

16. Compteur (1) selon l'une quelconque des revendications précédentes, dans lequel un signal de retour représentant l'état du commutateur est appliqué à un circuit d'excitation commandant l'actionneur en réponse au signal de commande.

17. Compteur (1) selon la revendication 16, dans lequel le signal de retour est émis sur la base d'une mesure électrique réalisée sur la ligne électrique.

18. Compteur (1) selon la revendication 16 ou 17, dans lequel le signal de retour est émis sur la base de la détection d'une position d'une pièce mécanique du commutateur.

19. Compteur (1) selon l'une quelconque des revendications 16 à 18, dans lequel le signal de retour et le signal de commande sont appliqués à un microprocesseur servant à commander l'actionneur en réponse au signal de commande.

20. Compteur (1) selon la revendication 19, dans lequel le microprocesseur fait partie du dispositif de mesure du compteur.

21. Compteur (1) selon l'une quelconque des revendications précédentes, incluant une pluralité de commutateurs de ligne électrique (3) disposés pour déconnecter les phases électriques respectives de la ligne électrique (2) en réponse au signal de commande (CS).

22. Compteur (1) selon la revendication 21, dans lequel la pluralité de commutateurs de ligne électrique (3) sont actionnés par un actionneur commun.

23. Compteur (1) selon la revendication 21, dans lequel la pluralité de commutateurs de ligne électrique (3) sont actionnés par leurs actionneurs respectifs.

24. Compteur (1) selon l'une quelconque des revendications 21 à 23, incluant un commutateur de ligne électrique (3) disposé pour déconnecter un conducteur neutre de la ligne électrique (2) en réponse au signal de commande (CS).

25. Compteur (1) selon la revendication 1, dans lequel le module de communication (1107) est aussi disposé pour transmettre la valeur de donnée représentant la quantité mesurée d'énergie électrique à un récepteur externe associé.

26. Compteur (1) selon la revendication 1 ou 25, dans lequel le module de communication (1107) est disposé pour transmettre des données représentant l'état du commutateur de ligne électrique (1106) à un récepteur externe associé.

27. Compteur (1) selon l'une quelconque des revendications 1 ou 25 ou 26, dans lequel le module de communication (1107) est disposé pour communiquer par l'intermédiaire de signaux radioélectriques sans fil.

28. Compteur (1) selon l'une quelconque des revendications 1 ou 25 à 27, dans lequel le module de communication (1107) est disposé pour communiquer par l'intermédiaire de la ligne d'alimentation électrique (2).

29. Compteur (1) selon l'une quelconque des revendications 1 ou 25 à 28, dans lequel le module de communication (1107) est disposé pour communiquer par l'intermédiaire d'un fil de communication dédié.

30. Système d'alimentation (100) destiné à alimenter en énergie électrique une pluralité de consommateurs associés par l'intermédiaire d'un réseau (200) de lignes d'alimentation électrique (201, 202, 203), le système incluant
- une pluralité de compteurs de consommation électrique (M1, M2, M3) selon l'une quelconque des revendications 1 ou 23 à 29, les compteurs (M1, M2, M3) étant disposés pour déconnecter les lignes d'alimentation électrique respectives (201, 202, 203) fournissant de l'énergie électrique à chacun des consommateurs associés lors de la réception des signaux de commande respectifs (CS1, CS2, CS3), et
- un transmetteur (T) disposé pour transmettre les signaux de commande respectifs (CS1, CS2, CS3) à la pluralité de compteurs de consommation électrique (M1, M2, M3) de manière à déconnecter l'alimentation en énergie électrique des consommateurs associés respectifs.

31. Système (100) selon la revendication 30, dans lequel le transmetteur (T) et les compteurs de consommation électrique (M1, M2, M3) sont disposés pour transmettre les signaux de commande (CS1, CS2, CS3) dans une configuration radioélectrique sans fil.

32. Système (100) selon la revendication 30 ou 31, dans lequel le transmetteur (T) et les compteurs de consommation électrique (M1, M2, M3) sont disposés pour transmettre les signaux de commande respectifs (CS1, CS2, CS3) par l'intermédiaire du réseau (200) de lignes d'alimentation électrique (201, 202, 203).

33. Système (100) selon l'une quelconque des revendications 30 à 32, dans lequel le transmetteur (T) et les compteurs de consommation électrique (M1, M2, M3) sont disposés pour transmettre les signaux de commande respectifs (CS1, CS2, CS3) par l'intermédiaire d'un fil de communication dédié.
